# EUROPEAN PATENT APPLICATION

(11) **EP 2 824 714 A1**
(43) Date of publication of application: **14.01.2015**
(21) Application number: 12870403.8
(22) Date of filing: 07.03.2012
(51) Int. Cl.: H01L 31/042

(54) **SOLAR CELL MODULE**

(71) Applicant: Sanyo Electric Co., Ltd., Moriguchi-shi, Osaka 570-8677 (JP)
(72) Inventor: YOSHIMINE, Yukihiro, Moriguchi-shi Osaka 570-8677 (JP); ISHIGURO, Tasuku, Moriguchi-shi Osaka 570-8677 (JP); IMADA, Naoto, Moriguchi-shi Osaka 570-8677 (JP)
(74) Representative: Glawe, Delfs, Moll
(86) International application number: PCT/JP2012/055758
(87) International publication number: WO 2013/132602

(57) **Abstract**

A solar cell module having an improved weather resistance is to be provided.

A solar cell module (1) includes a solar cell (12), a light-receiving side protection member (10), a back side protection member (11), and an encapsulant (13). The light-receiving side protection member (10) is made of a glass plate or a ceramic plate. The back side protection member (11) is made of a resin sheet. The encapsulant (13) contains an antioxidant. The encapsulant (13) includes: a back side encapsulant (13b) and a light-receiving side encapsulant (13a) . A content rate of the antioxidant in the back side encapsulant (13a) is higher than a content rate of the antioxidant in the light-receiving side encapsulant (13a).

## Description

### TECHNICAL FIELD

The invention relates to a solar cell module.

### BACKGROUND ART

Patent Document 1 discloses a solar cell module including solar cells provided inside an encapsulant filled in between a pair of protection members.

### PRIOR ART DOCUMENT

### PATENT DOCUMENT

Patent Document 1: Japanese Laid-open Patent Publication No. 2011-176231

### SUMMARY OF THE INVENTION

### PROBLEM TO BE SOLVED BY THE INVENTION

There is a demand for improvement in the weather resistance of a solar cell module.

A main objective of the invention is to provide a solar cell module having an improved weather resistance.

### MEANS FOR SOLVING THE PROBLEM

A solar cell module according to the invention includes a solar cell, a light-receiving side protection member, a back side protection member, and an encapsulant. The light-receiving side protection member is disposed at a light-receiving side of the solar cell. The light-receiving side protection member is made of a glass plate or a ceramic plate. The back side protection member is disposed at a back side of the solar cell. The back side protection member is made of a resin sheet. The encapsulant is filled in between the light-receiving side protection member and the back side protection member. The encapsulant seals the solar cell. The encapsulant contains an antioxidant. The encapsulant includes a back side encapsulant and a light-receiving side encapsulant. The back side encapsulant is located between the solar cell and the back side protection member. The light-receiving side encapsulant is located between the solar cell and the light-receiving side protection member. The content rate of the antioxidant in the back side encapsulant is higher than the content rate of the antioxidant in the light-receiving side encapsulant.

### EFFECT OF THE INVENTION

The invention can provide a solar cell module having an improved weather resistance.

### BRIEF DESCRIPTION OF THE DRAWINGS

[Fig. 1] Fig. 1 is a schematic plan view of a solar cell module according to a first embodiment.
[Fig. 2] Fig. 2 is a schematic cross-sectional view on line II-II in Fig. 1.
[Fig. 3] Fig. 3 is a schematic cross-sectional view on line III-III in Fig. 1.
[Fig. 4] Fig. 4 is a schematic cross-sectional view of a solar cell module according to a second embodiment.
[Fig. 5] Fig. 5 is a schematic back view of a solar cell module according to the second embodiment.

### MODE FOR CARRYING OUT THE INVENTION

Hereinafter, examples of preferred embodiments in which the invention is practiced are described. Note that, the following embodiments are mere examples. The invention is not limited the following embodiments.

Moreover, in the drawings referred in the embodiments and the like, the members having substantially same functions are referred as the same reference numerals. Moreover, the drawings referred in the embodiments and the like are schematically illustrated, and the ratios of sizes or the like of objects rendered in the drawings may differ from the ratios of sizes or the like of actual objects. The ratios of sizes or the like of objects may also differ among the drawings. The ratios of sizes or the like of specific objects should be determined in consideration of the following description.

### (First Embodiment)

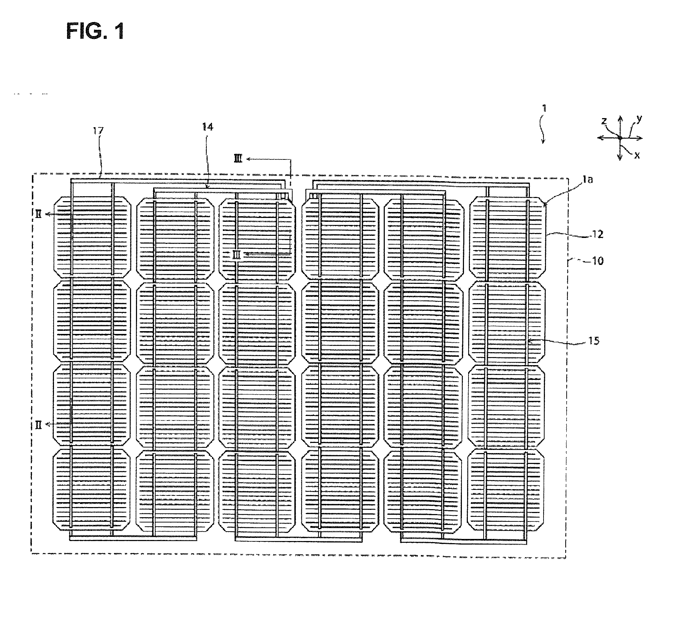

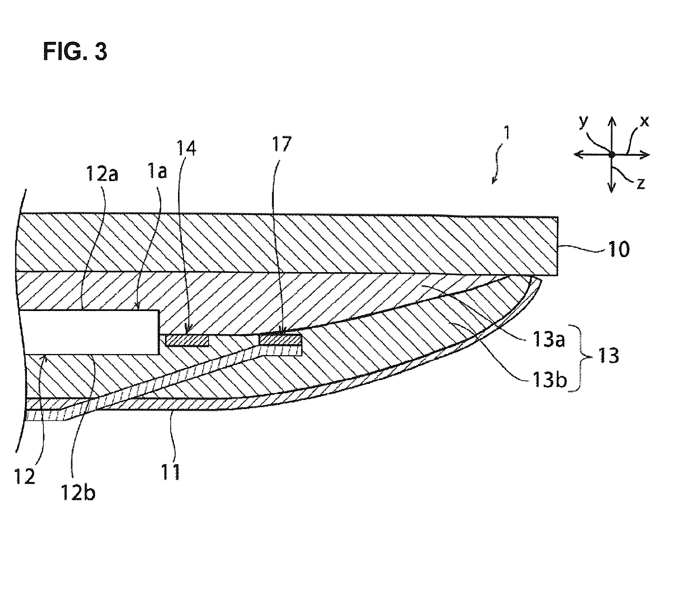

As illustrated in Fig. 1 to Fig. 3, solar cell module 1 includes multiple solar cell strings 1a. Multiple solar cell strings 1a are arranged at intervals in a y-axis direction. Multiple solar cell strings 1a are electrically connected to one another with wiring members 14 illustrated in Fig. 1 and Fig. 3. Lead electrodes 17 that are led out to the outside of solar cell module 1 are electrically connected to multiple solar cell strings 1a.

Each of solar cell strings 1a includes multiple solar cells 12. In each solar cell strings 1a, multiple solar cells 12 are arranged at intervals in an x-axis direction vertical to the y-axis direction. In each solar cell strings 1a, multiple solar cells 12 are electrically connected with wiring members 15.

In the embodiment, an example in which a solar cell module includes multiple solar cells is described; however, the invention is not limited to this configuration. A solar cell module according to the invention may include only one solar cell.

Solar cell 12 includes light-receiving surface 12a and back surface 12b. Herein, the "light-receiving surface" indicates a main surface on which light is mainly received. Solar cell 12 may generate power only when receiving light on light-receiving surface 12a, or may generate power not only when receiving light on light-receiving surface 12a, but also when receiving light on back surface 12b.

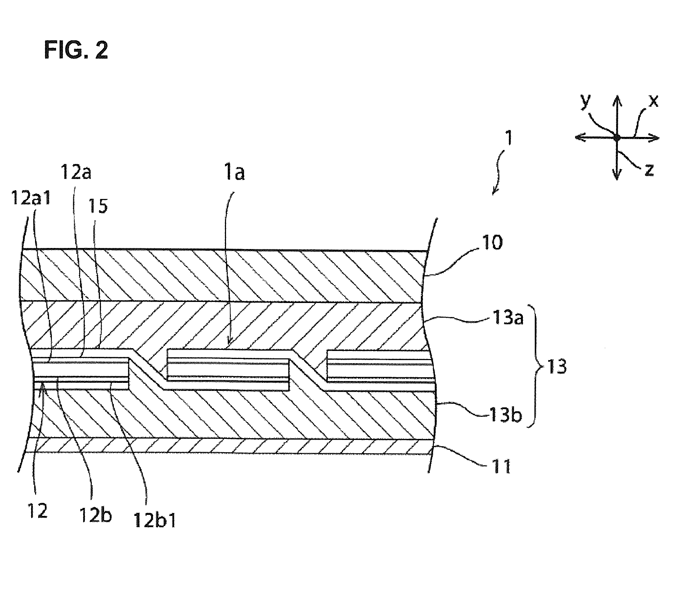

As illustrated in Fig. 2, solar cell 12 includes first electrode 12a1 on light-receiving surface 12a side, and second electrode 12b1 on a back surface 12b side. The area occupancy rate of first electrode 12a1 in light-receiving surface 12a is lower than the area occupancy rate of second electrode 12b1 in back surface 12b. First and second electrodes 12a1, 12b1 can be made of any appropriate conductive materials. First and second electrodes 12a1, 12b1 may contain Cu.

Light-receiving side protection member 10 is disposed on the light-receiving surface 12a side of solar cell 12. Light-receiving side protection member 10 may be made of, for example, a glass plate or a ceramic plate.

Back side protection member 11 is disposed on the back surface 12b side of solar cell 12. Back side protection member 11 is made of a resin sheet. The resin sheet may be made of only a resin, or may be made of a resin composition including a filler or the like. Back side protection member 11 includes no metal layer. The moisture vapor transmission rate of back side protection member 11 is higher than the moisture vapor transmission rate of light-receiving side protection member 10.

Sealant layer 13 is filled in between light-receiving side protection member 10 and back side protection member 11. Sealant layer 13 seals solar cells 12 that constitute solar cell strings 1a. Sealant layer 13 can be made of, for example, a resin composition containing a cross-linking resin such as an ethylene-vinyl acetate copolymer (EVA), a resin composition containing a non-crosslinking resin such as polyolefin, or the like.

Sealant layer 13 contains an antioxidant. Specific examples of the antioxidant include, for example, monophenol-based, bisphenol-based, high molecular weight phenol-based, sulfur-based, and phosphite-based antioxidants, and combinations of these antioxidants, and the like.

Sealant layer 13 includes light-receiving side encapsulant 13a and back side encapsulant 13b. Light-receiving side encapsulant 13a is disposed between solar cells 12 and light-receiving side protection member 10. Meanwhile, back side encapsulant 13b is disposed between solar cells 12 and back side protection member 11.

The content rate of the antioxidant in back side encapsulant 13b is higher than the content rate of the antioxidant in light-receiving side encapsulant 13a. The content rate of the antioxidant in back side encapsulant 13b is preferably twice or more of the content rate of the antioxidant in light-receiving side encapsulant 13a, and more preferably five times or more.

The thickness of light-receiving side encapsulant 13a in end portions of solar cell module 1 is thinner than the thickness of light-receiving side encapsulant 13a in a center portion of solar cell module 1. In the end portions of solar cell module 1, the thickness of light-receiving side encapsulant 13a gradually decreases toward the outside.

In the end portions of solar cell module 1, encapsulant 13 is formed only of back side encapsulant 13b having a relatively high content rate of the antioxidant. Accordingly, light-receiving side encapsulant 13a having a relatively low content rate of the antioxidant is covered with light-receiving side protection member 10 and back side encapsulant 13b, and is not exposed at an edge surface of solar cell module 1.

An end portion of wiring member 14 that connects wiring members 15 to each other is located inside back side encapsulant 13b. Specifically, a substantially entire wiring member 14 and a substantially entire part of lead electrode 17 located inside encapsulant 13 are located inside back side encapsulant 13b.

From the viewpoint of preventing ingress of the moisture into a solar cell module, it is preferable to form the back side protection member by using a resin sheet containing a metal layer. However, the resin sheet containing the metal layer has a low moisture vapor transmission rate. Accordingly, when the back side protection member is made of a resin sheet containing a metal layer, the moisture having entered the solar cell module is difficult to discharge.

In contrast, in solar cell module 1, back side protection member 11 is made of a resin sheet containing no metal layer. For this reason, back side protection member 11 has a high moisture vapor transmission rate. Therefore, the moisture having entered solar cell module 1 can be easily discharged through back side protection member 11.

Back side protection member 11 made of a resin sheet having no barrier layer has a high oxygen permeability. However, in solar cell module 1, encapsulant 13 contains the antioxidant. This prevents characteristic degradation which would be otherwise caused by oxygen having entered solar cell module 1, for example, due to a facture such as oxidation of electrodes 12a1, 12b1 containing Cu.

From the viewpoint of preventing degradation due to oxygen having entered the solar cell module, it is preferable to increase the content rate of the antioxidant in the entire encapsulant. However, in this case, the light transmittance in the light-receiving side encapsulant is lowered, and accordingly the output characteristic of the solar cell module decreases.

In contrast, in solar cell module 1, the content rate of the antioxidant in back side encapsulant 13b is relatively high, whereas the content rate of the antioxidant in light-receiving side encapsulant 13a is relatively low. Thus, characteristic degradation due to oxygen having entered solar cell module 1 from the back side is less likely to occur, and the lowering of the light transmittance in light-receiving side encapsulant 13a is suppressed. Hence, solar cell module 1 having an improved weather resistance and an improved output characteristic can be achieved. From the viewpoint of obtaining solar cell module 1 having a further improved output characteristic, the content rate of the antioxidant in light-receiving side encapsulant 13a is preferably 1% by mass or less, and more preferably substantially zero.

Note that, since light-receiving side protection member 10 is made of a glass plate or a ceramic plate, the oxygen permeability of light-receiving side protection member 10 is lower than the oxygen permeability of back side protection member 11. Therefore, oxygen is less likely to enter solar cell module 1 through light-receiving side protection member 10. Accordingly, even when the content rate of the antioxidant in light-receiving side encapsulant 13a is lowered, degradation due to oxygen is less likely to occur.

In solar cell module 1, the thickness of light-receiving side encapsulant 13a in the end portions of solar cell module 1 is thinner than the thickness of light-receiving side encapsulant 13a in the center portion of solar cell module 1. Back side protection member 11 has a moisture vapor transmission rate and an oxygen permeability smaller than those of light-receiving side filler 13a. This facilitates prevention of the ingress of the moisture and the ingress of oxygen from the edge surface of solar cell module 1.

In the end portions of solar cell module 1, encapsulant 13 is formed by back side encapsulant 13b having a relatively high content rate of the antioxidant. This can prevent degradation due to oxygen entering from the end portions of solar cell module 1.

The end portion of wiring member 14 which connects wiring members 15 to each other is located inside back side encapsulant 13b. This prevents oxidation of the end portion of wiring member 14. This configuration is especially effective when wiring member 14 is made of a Cu material coated with an Ag film or the like, and the Cu material which tends to be easily oxidized is exposed at the end portion.

Hereinafter, another preferable embodiment of the invention is described. In the following description, the common numerals are given to the common members having functions substantially common to those in the abovementioned first embodiment, and the description thereof is omitted.

### (Second Embodiment)

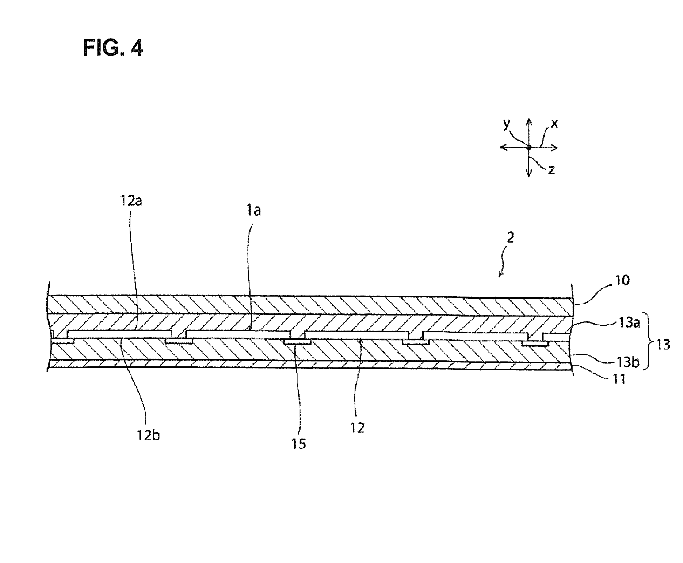

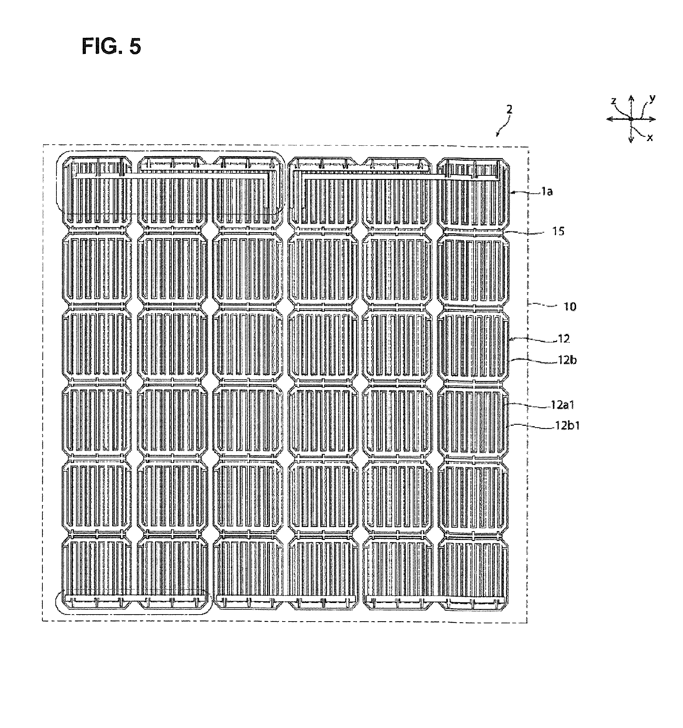

AS illustrated in Fig. 4 and Fig. 5, in solar cell module 2, solar cell 12 is a back contact solar cell including both electrodes 12a1, 12b1 on the back surface 12b side (see Fig. 5). Also in this case, making the content rate of the antioxidant in back side encapsulant 13b be higher than the content rate of the antioxidant in light-receiving side encapsulant 13a can achieve both of the improved output characteristic and the improved weather resistance.

Back contact solar cell 12 has a low photoelectric conversion efficiency at the back surface. Accordingly, solar cell module 2 provided with back contact solar cells 12 is more unlikely to have output characteristic lowered even when back side encapsulant 13b has a low light transmittance because of a high content rate of the antioxidant in back side encapsulant 13b. This can result in achievement of the further improved output characteristic and the further improved weather resistance.

### EXPLANATION OF THE REFERENCE NUMERALS

- 1, 2: solar cell module
- 10: light-receiving side protection member
- 11: back side protection member
- 12: solar cell
- 12a: light-receiving surface
- 12a1: first electrode
- 12b: back surface
- 12b1: second electrode
- 13: encapsulant
- 13a: light-receiving side encapsulant
- 13b: back side encapsulant
- 14, 15: wiring member

## Claims

1. A solar cell module comprising:
a solar cell;
a light-receiving side protection member disposed on a light-receiving side of the solar cell, and made of a glass plate or a ceramic plate;
a back side protection member disposed on a back side of the solar cell, and made of a resin sheet; and
an encapsulant being filled in between the light-receiving side protection member and the back side protection member, sealing the solar cell, and containing an antioxidant, wherein
the encapsulant includes:
a back side encapsulant located between the solar cell and the back side protection member; and
a light-receiving side encapsulant located between the solar cell and the light-receiving side protection member, and
a content rate of the antioxidant in the back side encapsulant is higher than a content rate of the antioxidant in the light-receiving side encapsulant.

2. The solar cell module according to claim 1, wherein, the solar cell includes an electrode provided on the back side and containing Cu.

3. The solar cell module according to claim 1 or 2, wherein
the solar cell includes a first electrode and a second electrode, and
both of the first electrode and the second electrode are provided on the back side of the solar cell.

4. The solar cell module according to any one of claims 1 to 3, wherein
a thickness of the light-receiving side encapsulant in end portions of the solar cell module is thinner than a thickness of the light-receiving side encapsulant in a center portion thereof.

5. The solar cell module according to any one of claims 1 to 4, wherein
in end portions of the solar cell module, the encapsulant is formed of the back side encapsulant.

6. The solar cell module according to any one of claims 1 to 5, further comprising:
first wiring members electrically connected the solar cell; and
a second wiring member electrically connecting the first wiring members to each other, wherein
an end portion of the second wiring member is located inside the back side encapsulant.

7. The solar cell module according to any one of claims 1 to 6, wherein
an oxygen permeability of the light-receiving side protection member is lower than an oxygen permeability of the back side protection member.

8. The solar cell module according to any one of claims 1 to 7, wherein
the content rate of the antioxidant in the back side encapsulant is twice or more of the content rate of the antioxidant in the light-receiving side encapsulant.
